## Europäisches Patentamt

## European Patent Office

## Office européen des brevets

(11) Numéro de publication: **0 228 312**

**A1**

(12) # DEMANDE DE BREVET EUROPEEN

(21) Numéro de dépôt: **86402399.9**

(22) Date de dépôt: **27.10.86**

(51) Int. Cl.4: **H 03 K 17/78**
**H 01 L 31/08**

(30) Priorité: **31.10.85 FR 8516210**

(43) Date de publication de la demande:
**08.07.87 Bulletin 87/28**

(84) Etats contractants désignés: **DE FR GB**

(71) Demandeur: **COMMISSARIAT A L'ENERGIE ATOMIQUE Etablissement de Caractère Scientifique Technique et Industriel**
**31/33, rue de la Fédération**
**F-75015 Paris (FR)**

**CENTRE NATIONAL DE LA RECHERCHE SCIENTIFIQUE (CNRS)**
**15, Quai Anatole France**
**F-75700 Paris (FR)**

(72) Inventeur: **Koster, Alain Georges**
**27 Bis, Avenue des Platanes**
**F-91400 Orsay (FR)**

**Laval, Suzanne**
**14, rue des Bleuets**
**F-91440 Bures sur Yvette (FR)**

(74) Mandataire: **Mongrédien, André et al**
**c/o BREVATOME 25, rue de Ponthieu**
**F-75008 Paris (FR)**

(54) Commutateur opto-électronique à seuil de puissance et son procédé de commande.

(57) L'invention concerne un commutateur optoélectronique à seuil de puissance et son procédé de commande. Ce commutateur permettant d'établir sous l'effet d'un faisceau de lumière impulsionnelle (13) à partir d'un seuil de puissance déterminé, un court-circuit entre une première et une deuxième électrodes (5, 7) espacées de façon à former un espace inter-électrodes (11), comprend des moyens (10) pour appliquer une tension d'alimentation la première électrode, une couche guidante semi-conductrice (21), disposée sur un substrat isolant (19), les électrodes étant disposées sur cette couche et un réseau optique de diffraction (23) gravé dans la couche guidante dans l'espace interélectrodes (11), la nature et l'épaisseur de la couche guidante (21) ainsi que le pas du réseau et l'angle d'incidence du faisce = u étant choisis pour obtenir lors du passage de la puissance du faisceau de lumière par le seuil de puissance, le passage rapide d'un état de couplage très faible de la lumière incidente dans la couche guidante à un couplage résonnant permettant de réaliser le court-circuit.

FIG. 2a

## Description

COMMUTATEUR OPTO-ELECTRONIQUE A SEUIL DE PUISSANCE ET SON PROCEDE DE COMMANDE

La présente invention concerne un commutateur opto-électronique à seuil de puissance, ainsi que son procédé de commande.

Cette invention s'applique dans des domaines très vastes tels que le domaine de l'instrumentation des systèmes laser, en particulier pour la synchronisation de différents signaux optiques et électriques pour la commande de cellules de Pockels, pour le découpage ou l'extraction d'impulsions laser.

Un commutateur opto-électronique est un dispositif permettant d'établir, sous l'effet d'un faisceau lumineux incident, une conduction électrique entre deux électrodes normalement isolées.

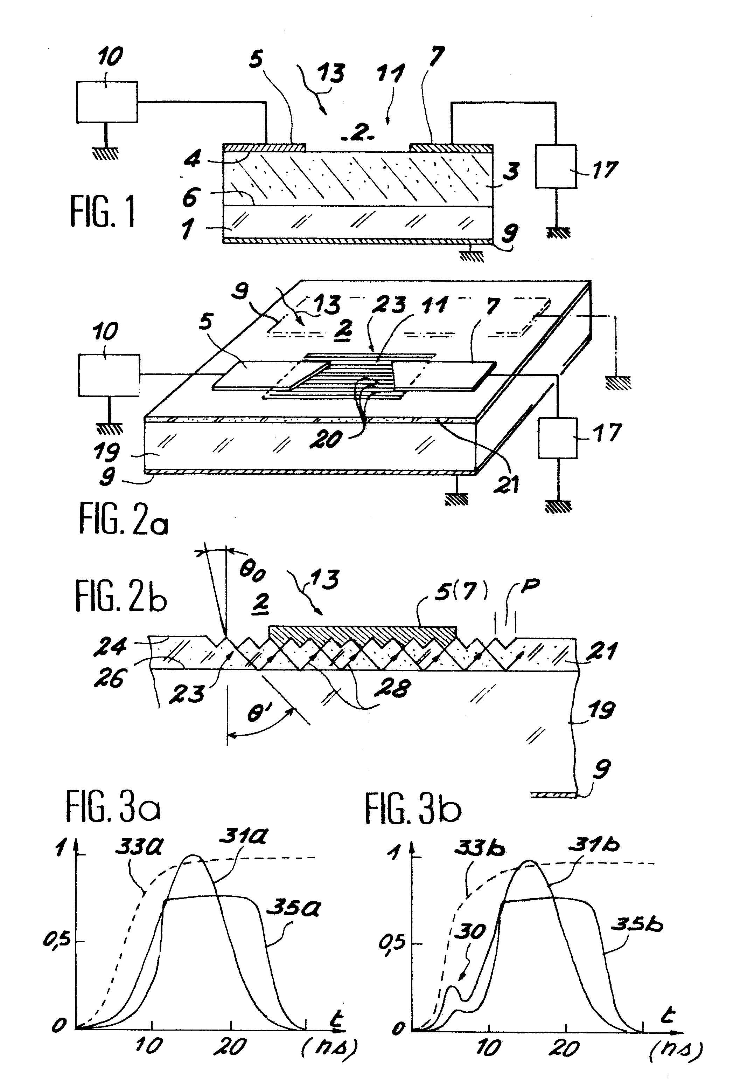

La figure 1 représente schématiquement en coupe un commutateur opto-électronique connu.

Ce commutateur comprend une couche 3 constituée par un matériau photoconducteur semi-conducteur, d'épaisseur par exemple de l'ordre de 100 μm, intercalée entre un premier et éventuellement un deux substrats 2, 1. Le premier substrat 2 est constitué par l'air ambiant, le deuxième substrat 1 lorsqu'il existe est constitué par un matériau isolant tel que l'alumine.

Ce commutateur comprend en outre une première et une deuxième électrodes 5, 7 normalement isolées et déposées sur la surface supérieure de la couche 3, ainsi qu'une électrode de référence 9 déposée sur toute la surface inférieure du substrat 1 lorsqu'il existe ou si le substrat 1 n'existe pas sur toute la surface inférieure de la couche 3, formant avec les électrodes 5, 7 une ligne de propagation. Les première et deuxième électrodes 5, 7 sont alignées et espacées de façon à former un espace inter-électrodes 11.

On entend par surface supérieure par opposition à surface inférieure, la surface la plus proche du faisceau de lumière incident.

L'électrode 5 est reliée à des moyens 10 tels qu'un générateur de tension, permettant d'appliquer une tension d'alimentation à cette électrode 5.

L'électrode 7 est reliée des moyens 17 d'observation et/ou d'utilisation d'impédance adaptée à l'impédance de la ligne de propagation formée par les électrodes 5, 7 et 9 ; cette impédance est généralement une résistance de 50Ω. Par ailleurs, ces moyens 10, 17 et l'électrode de référence 9 sont reliés à une masse de référence.

Les moyens 17 d'observation et/ou d'utilisation recueillent le signal électrique reçu par l'électrode 7 lorsqu'une conduction électrique est établie entre les électrodes 5 et 7. Ce signal électrique correspond à la tension de sortie du commutateur.

Pour établir une conduction électrique entre les deux électrodes 5, 7, un faisceau de lumière 13 incidente impulsionnelle provenant d'une source lumineuse telle qu'une source laser est envoyé sur la couche 3 dans l'espace inter-électrodes 11. La longueur d'onde de ce faisceau 13 doit être telle que l'énergie des photons de ce faisceau soit comprise dans la bande d'absorption du matériau constituant la couche 3, ou voisine du bord de cette bande. Pour une couche en silicium, on peut choisir par exemple une source lumineuse telle qu'un laser à néodyme de longueur d'onde 1,06 μm.

Dans ces conditions, la partie du faisceau lumineux 13 qui pénètre dans la couche 3 est en partie absorbée dans la couche 3. Lors de son passage dans la couche 3, la fraction du faisceau 13 absorbée crée des paires électrons-trous dans le matériau constituant cette couche 3. Ces paires électrons-trous sont des porteurs de charges qui permettent d'établir une conduction électrique entre les deux électrodes 5, 7.

Lorsque ces porteurs de charge sont suffisamment nombreux, ils permettent d'établir un court-circuit entre les deux électrodes 5, 7, établissant ainsi une continuité électrique entre ces électrodes 5, 7.

La suppression du faisceau lumineux 13, envoyé dans l'espace inter-électrodes 11 permet d'isoler électriquement à nouveau les deux électrodes 5, 7, après que les porteurs de charge aient disparu par recombinaison.

Le front de montée du signal électrique recueilli par les moyens 17 d'observation et/ou d'utilisation dépend de la forme du signal lumineux du faisceau 13 incident. Généralement la forme de ce signal lumineux n'est pas reproductible, aussi la forme du signal électrique délivré par l'électrode 7 au cours de différentes utilisations du commutateur n'est pas non plus reproductible, conduisant à chaque utilisation du commutateur, à une incertitude sur l'instant de déclenchement du commutateur. On entend par déclenchement du commutateur l'instant où les électrodes 5, 7 sont en court-circuit.

Ce manque de reproductibilité du signal électrique, obtenu à partir d'un faisceau lumineux impulsionnel, peut par exemple, dans le cas où le commutateur est utilisé pour synchroniser des appareils d'observation, entraîner des défauts de synchronisation, pouvant être du même ordre de grandeur ou supérieurs aux temps caractéristiques des phénonènes à étudier. Aussi plus les impulsions lumineuses sont courtes, par exemple de l'ordre de la nanoseconde ou de la picose conde, plus les problémes de synchronisation deviennent critiques.

Par ailleurs, lorsque l'électrode de référence 9 est disposée sur la surface inférieure de la couche 3, autrement dit lorsque le commutateur ne comporte pas de substrat 1, la création de porteurs de charge dans toute l'épaisseur de la couche 3 peut entraîner un court-circuit entre les électrodes 5 et 7 et l'électrode de référence 9. L'épaisseur importante de la couche 3 ne permet pas d'autre part de conserver une impédance constante de la ligne de propagation formée par les électrodes 5, 7 et 9, et cela se traduit par des perturbations du signal électrique.

La présente invention a justement pour objet un commutateur opto-électronique permettant de remédier à ces inconvénients. Ce commutateur permet en particulier d'établir un court-circuit, notamment haute tension, entre deux électrodes sous l'effet d'impulsions lumineuses. Par ailleurs, le commutateur conforme l'invention est déclenché partir d'un seuil de puissance lumineuse, permettant ainsi de s'affranchir de la forme du signal lumineux d'un faisceau incident impulsionnel, avant que le seuil de puissance du faisceau soit atteint.

De façon plus précise, l'invention a pour objet un commutateur opto-électronique à seuil de puissance, permettant d'établir sous l'effet d'un faisceau de lumière incidente impulsionnelle monochromatique et parallèle une conduction électrique momentanée entre une première et une deuxième électrodes normalement isolées, alignées et espacées de façon à former un espace inter-électrodes, comprenant des moyens pour appliquer une tension d'alimentation à la première électrode ; ce commutateur est caractérisé en ce qu'il comprend une couche guidante semi-conductrice, disposée sur un substrat isolant et servant au transport des ondes lumineuses incidentes, la première et la deuxième électrodes étant déposées sur la surface supérieure de cette couche guidante, un réseau optique de diffraction étant gravé dans la couche guidante dans l'espace inter-électrodes, la nature et l'épaisseur de la couche guidante ainsi que le pas du réseau et l'angle d'incidence du faisceau étant choisis pour obtenir lors du passage de la puissance du faisceau de lumière par un seuil de puissance déterminé, le passage rapide d'un état de couplage très faible de la lumière incidente dans la couche guidante à un couplage résonnant.

Le réseau optique de diffraction est constitué de sillons gravés dans la couche guidante, parallèles entre eux et parallèles à la direction d'alignement des première et deuxième électrodes, le pas du réseau correspondant à l'espacement desdits sillons entre eux.

L'utilisation d'un réseau optique de diffraction gravé dans la couche guidante permet d'augmenter considérablement l'absorption du faisceau lumineux, en couplant le faisceau lumineux à la couche guidante.

On entend par couplage d'un faisceau lumineux dans la couche guidante, l'excitation d'un mode de propagation ou mode guidé de la couche guidante. Une partie de la lumière d'un faisceau couplé à un mode de propagation de la couche guidante pénètre dans cette couche. Cette partie de la lumière est alors transportée dans la couche guidante suivant ce mode de propagation ; une fraction de cette lumière est alors absorbée dans la couche en créant sur son passage des porteurs de charge et le reste est diffracté. Un couplage résonnant correspond à une absorption maximum du faisceau lumineux incident.

L'excitation d'un mode guidé dans la couche guidante se fait de façon résonnante, pour un faisceau lumineux de faible puissance, c'est-à-dire de puissance inférieure à la puissance lumineuse nécessaire pour induire une variation de l'indice de réfraction dans la couche guidante, pour un angle d'incidence $\Theta_0$ déterminé, fonction des caractéristiques de la couche guidante, c'est-à-dire de la nature et de l'épaisseur de cette couche et du pas du réseau de diffraction.

Si on fixe l'angle d'incidence $\Theta_i$ du faisceau lumineux incident de façon à ce qu'à faible puissance, l'excitation d'un mode guidé ne soit pas résonnante ($\Theta_i$ étant compris entre $\Theta_0$ et $\Theta_0 \pm \Delta\Theta$) lorsque la puissance augmente la fraction de lumière guidée dans la couche en modifie l'indice de réfraction. Si cette modification d'indice est de signe convenable, on se rapproche des conditions de résonance qui ne correspondent plus à l'angle d'indice $\Theta_0$, et le phénomène s'autoaccélère : de plus en plus de lumière est guidée dans la couche, modifiant d'autant plus l'indice de réfraction. Ce phénomène d'avalanche a lieu dès que la puissance lumineuse incidente passe par un seuil de puissance dont la valeur est fonction de l'écart $\Theta_i - \Theta_0$ et permet de passer rapidement d'un état de très faible couplage, donc de faible conductivité électrique, à un état de couplage résonnant où la puissance lumineuse dans la couche est élevée et permet d'établir un court-circuit entre les deux électrodes.

La variation de l'indice de réfraction de la couche guidante en fonction de la puissance lumineuse dans la couche guidante correspond à un fonctionnement en régime non-linéaire du commutateur et permet le fonctionnement du commutateur avec un seuil de puissance.

Bien entendu, ce seuil de puissance est supérieur ou égal à la puissance lumineuse minimale nécessaire pour induire une variation brusque de l'indice de réfraction de la couche guidante.

La largeur angulaire de couplage $\Delta\Theta$ est déterminée par l'ensemble des angles d'indicence permettant de coupler des faisceaux lumineux à la couche guidante, elle dépend de l'absorption du matériau formant la couche guidante et des caractéristiques géométriques du réseau de diffraction.

De façon avantageuse, l'épaisseur de la couche guidante étant de l'ordre de grandeur de la longueur d'onde de la lumière incidente, l'angle d'incidence de cette dernière sur le réseau est choisi pour que le couplage ait lieu selon un mode fondamental de propagation de la lumière dans la couche guidante.

On choisit l'épaisseur de la couche guidante de l'ordre de grandeur de la longueur d'onde du faisceau lumineux, pour que cette couche ne comporte que très peu de modes de propagation.

En effet, plus l'épaisseur de la couche guidante est faible, moins elle possède de modes de propagation. Cependant, pour contenir au moins un mode de propagation, son épaisseur doit être supérieure 0,3 µm dans le cas du silicium.

De préférence, la longueur du réseau optique de diffraction est supérieure celle de l'espace inter-électrodes, ledit réseau étant situé en partie sous les première et deuxième électrodes.

Selon un mode préféré de réalisation, l'espace inter-électrodes a la forme d'un triangle tronqué au sommet, l'angle au sommet étant par exemple de l'ordre de 5°.

De cette façon, la propagation d'un mode guidé se prolonge sous les première et deuxième électrodes, et les porteurs de charge qui y sont créés permettent d'améliorer les contacts électriques entre les première et deuxième électrodes et la couche guidante.

De façon avantageuse, la largeur du réseau optique de diffraction est au moins égale à celle de l'espace inter-électrodes.

Selon un mode de réalisation du commutateur opto-électronique, il comprend en outre une électrode de référence isolée des première et deuxième électrodes, sur la surface supérieure de la couche guidante ou sur la surface inférieure du substrat, formant avec elles une ligne de propagation et portée à un potentiel de référence tel que la masse.

Lorsque l'électrode de référence est sur la surface supérieure de la couche guidante, elle est constituée soit de deux électrodes situées de part et d'autre des première et deuxième électrodes, soit d'une seule électrode située d'un seul côté desdites électrodes.

De préférence, le substrat est du saphir, et la couche guidante est un semi-conducteur tel que du silicium généralement épitaxié sur le substrat.

L'invention a aussi pour objet un procédé de commande du commutateur opto-électronique conforme à l'invention, un court-circuit est obtenu entre les première et deuxième électrodes sous l'effet d'un faisceau de lumière incidente impulsionnelle monochromatique et parallèle, envoyé sur le réseau optique de diffraction avec un angle d'incidence $\Theta_i$ et une puissance supérieure ou égale à un seuil de puissance $P_{si}$, le seuil de puissance $P_{si}$ correspondant à la puissance minimale nécessaire à l'obtention rapide d'un couplage résonnant dans la couche guidante du faisceau de lumière d'angle d'incidence $\Theta_i$, différent de $\Theta_0$ et compris entre $\Theta_0$ et $\Theta_0 \mp \Delta\Theta$, l'angle d'incidence $\Theta_0$ correspondant à un couplage résonnant dans la couche guidante d'un faisceau de lumière de puissance inférieure à la puissance minimale nécessaire pour induire une variation de l'indice de réfraction de la couche guidante et $\Delta\Theta$ correspondant à la largeur angulaire de couplage.

D'autres caractéristiques et avantages de l'invention ressortiront mieux de la description qui va suivre donnée à titre purement illustratif et non limitatif. La description est faite en référence aux figures 2a à 3b annexées dans lesquelles :

- la figure 2a représente schématiquement un exemple de réalisation d'un commutateur opto-électronique selon l'invention,

- la figure 2b représente schématiquement une coupe transversale du commutateur de la figure 2a au niveau de l'espace inter-électrodes, selon le plan d'incidence du faisceau de lumière incident, et

- les figures 3a et 3b représentent les tensions de sortie d'un commutateur classique du type de celui décrit figure 1 et d'un commutateur conforme à l'invention, avec une impulsion lumineuse respectivement sans défaut et avec un défaut.

Le commutateur opto-électronique conforme à l'invention représenté figures 2a et 2b comprend une couche guidante 21 intercalée entre un substrat 19 et l'air 2. La couche guidante 21 a un indice de réfraction supérieur aux indices de réfraction du substrat 19 et de l'air. Cette couche guidante 21 est réalisée par un matériau photo-conducteur semi-conducteur tel que du silicium, et le substrat 19 est constitué par un matériau isolant tel que du corindon (Al₂O₃) appelé généralement saphir.

Ce commutateur comprend en outre une première et une deuxième électrodes 5, 7 normalement isolées, déposées sur la couche guidante 21, ainsi qu'une électrode de référence 9 déposée sur toute la surface inférieure du substrat 19. Cette électrode de référence 9 peut également être déposée sur la surface supérieure de la couche guidante 21 parallèlement aux première et deuxième électrodes 5, 7, comme représenté en traits mixtes sur la figure 2a, dans ce cas il n'y a pas d'électrode de référence sur la surface inférieure du substrat. L'ensemble des électrodes 5, 7 et 9 constitue une ligne de propagation. Les première et deuxième électrodes 5, 7 sont en outre alignées et espacées de façon à former un espace inter-électrodes 11.

Par ailleurs, le commutateur de l'invention comprend un organe de couplage tel qu'un réseau de diffraction 23 gravé dans la couche guidante 21 sur une longueur au moins égale à celle de l'espace inter-électrodes 11. Ce réseau de diffraction est constitué de sillons 20 parallèles, régulièrement espacés. Les axes longitudinaux de ces sillons sont parallèles à 1 direction d'alignement des électrodes 5, 7.

Une tension d'alimentation est appliquée à l'électrode 5 par des moyens 10 tels qu'un générateur de tension. L'électrode 7 est reliée à des moyens 17 d'observation et/ou d'utilisation d'impédance adaptée à la ligne de propagation formée par les électrodes 5, 7 et 9. Ces moyens 10, 17 ainsi que l'électrode 9 sont reliés à une masse de référence.

La couche guidante a de façon avantageuse une faible épaisseur, de l'ordre de grandeur de la longueur d'onde du faisceau lumineux 13 envoyé sur le réseau de couplage du commutateur, pour être monomode ou très faiblement multimodes.

Plus l'épaisseur de la couche guidante 21 est faible, moins elle comporte de modes de propagation. On utilise généralement les modes de propagation fondamentaux : transverse électrique ou transverse magnétique, notés TE et TM, de la couche guidante 21.

Par ailleurs, la longueur d'onde de ce faisceau doit être telle que l'énergie des photons de ce faisceau soit voisine du bord de la bande d'absorption du matériau constituant la couche guidante.

Ainsi, pour une couche guidante en silicium, on choisit par exemple un faisceau lumineux issu d'un laser à néodyme de longueur d'onde $\lambda = 1,06$ µm et l'épaisseur de la couche guidante de l'ordre de 1 µm.

Le choix et l'épaisseur du substrat 19 sont conditionnés notamment par les valeurs des tensions de sortie recueillies par l'électrode 7, compte tenu de l'isolation électrique du substrat 19. Le substrat 19 est choisi de préférence en saphir, celui-ci présentant une bonne rigidité diélectrique. Pour des tensions de sortie de l'ordre de 5 kV, on choisit un substrat en saphir d'épaisseur 1 mm.

Pour obtenir une bonne qualité optique, la couche guidante 21 est de façon avantageuse épitaxiée sur le substrat 19 ; ceci facilite par ailleurs la manipulation du matériau constituant la couche guidante et les problèmes de contact thermique entre la couche guidante 21 et le substrat 19.

Pour graver le réseau 23 sur la couche guidante 21, un réseau en résine est préalablement réalisé à la surface de la couche guidante 21. Ce réseau en résine est obtenu par insolation d'une couche de résine photosensible avec une source lumineuse telle qu'un laser HeCd de longueur d'onde environ 4400 Å, au moyen d'un système de franges d'interférence. Après développement de la résine photosensible, le réseau obtenu dans la résine est transféré dans la couche guidante 21 par gravure ionique ou chimique de la couche 21 à travers le réseau de résine. Cette opération de gravure permet alors d'obtenir le réseau de diffraction 23. S'il n'a pas entièrement disparu au cours de l'opéra tion de gravure, le réseau de résine doit être éliminé.

Le pas du réseau est choisi de préférence de l'ordre de 0,3 µm de façon à n'avoir qu'un seul ordre de diffraction et la profondeur de modulation de ce réseau est de façon avantageuse comprise entre 800 et 1500 Å ; dans ces conditions, l'efficacité du couplage entre la lumière incidente et la couche guidante est maximum.

Pour obtenir des contacts ohmiques entre les électrodes 5, 7 et la couche guidante 21, on réalise ces électrodes par exemple, par dépôt d'un matériau conducteur tel que l'or ou l'aluminium, sur la surface supérieure de la couche guidante 21 et on fait suivre ce dépôt d'un traitement thermique approprié pour obtenir ces contacts. Ce dépôt de matériau conducteur est réalisé par des techniques connues telles que la technique (en terminologie anglo-saxonne "lift-off") consistant à former par photolithographie un masque de résine sur la couche 21, la résine étant présente uniquement aux endroits où ce dépôt conducteur ne doit pas être effectué, à déposer le matériau conducteur sur l'ensemble de la couche et éliminer la partie du dépôt conducteur située au-dessus de la résine par dissolution de celle-ci. L'épaisseur des électrodes est prise par exemple égale à 1 µm ; d'autre part, pour avoir une impédance caractéristique de 50Ω, les électrodes 5, 7 ont une largeur égale à 1,14 fois l'épaisseur du substrat 19 lorsque ce dernier est en saphir.

La distance inter-électrodes est fonction de la tension d'alimentation appliquée à l'électrode 5. En effet, plus la distance inter-électrodes est grande, plus la résistance électrique entre les deux électrodes est grande et plus les électrodes peuvent soutenir de fortes tensions.

Le reste de la description permet de compren dre le fonctionnement du commutateur opto-électronique conforme à l'invention.

En l'absence de couplage, l'absorption lumineuse d'un faisceau incident de longueur d'onde λ = 1,06 µm dans une couche guidante de faible épaisseur, de l'ordre de 1 µm, est très faible. Le réseau de diffraction 23, gravé dans la couche guidante 21 permet d'améliorer l'absorption lumineuse dans cette couche 21, en couplant dans cette couche le faisceau lumineux incident 13 polarisé de façon à exciter un mode de propagation de la couche guidante 21. Une fraction importante de l'énergie lumineuse d'un faisceau incident couplé sur un mode de propagation de la couche 21 peut ainsi être absorbée dans cette couche. La densité de puissance de l'onde lumineuse guidée dans la couche est très supérieure à la densité de puissance du faisceau incident du fait de la propagation guidée dans une couche guidante mince.

Un faisceau lumineux incident 13 est couplé à un mode de propagation de la couche guidante 21, lorsque l'angle d'indicence dudit faisceau 13, sur le réseau 23, est compris dans la fenêtre angulaire appelée largeur angulaire de couplage $\Delta\theta$.

La partie de la lumière d'un faisceau couplé, qui pénètre dans la couche 21 est réfléchie sur les parois internes 24, 26 de la couche 21 suivant le mode de propagation correspondant et la fraction de cette lumière absorbée crée sur son passage des porteurs de charge. La direction du mode de propagation est perpendiculaire à la direction d'alignement des électrodes 5, 7. Les parois 24, 26 correspondent respectivement à l'interface couche guidante 21-air et à l'interface couche guidante 21-substrat 19.

Un couplage résonnant correspond, comme on l'a vu précédemment, à l'absorption maximum du faisceau lumineux incident qui subit des réflexions successives 28 en phase dans la couche guidante 21. On entend par réflexions en phase , des réflexions dans la couche 21 de même angle $\theta'$ par rapport à la normale aux parois 24, 26 et telles que le rayons dans la couche arrivant en un même point de cette couche mais issus de rayons incidents ayant pénétré dans la couche en différents endroits et ayant donc subi un nombre différent de réflexions dans cette couche soient tous en phase. Un faisceau réfléchi successivement en phase dans la couche guidante 21 ne perd pratiquement pas d'énergie par diffraction hors de la couche guidante 21 ; ces réflexions en phases correspondent donc à un minimum de perte d'énergie vers l'extérieur et donc à un couplage résonnant ou maximum.

En régime linéaire, autrement dit pour un faisceau de lumière de puissance inférieure à la puissance minimale nécessaire pour induire une variation de l'indice de réfraction de la couche 21, le couplage est résonnant pour l'angle d'incidence $\theta_0$ défini par l'équation : $\frac{2\pi}{\lambda} \sin\theta_0 + \frac{2\pi}{p} - \beta_k = 0$

où λ est la longueur d'onde du faisceau incident 13, p est le pas du réseau et $\beta_k$ est la constante de propagation du mode d'ordre k, qui est fonction de l'épaisseur et de la nature de la couche guidante.

La largeur angulaire de couplage $\Delta\theta$ à puissance moitié, en fonction de l'angle d'incidence $\theta_0$ est égale à :

$$\Delta\theta = \frac{\alpha_k + 2\gamma_k}{\frac{2\pi}{\lambda}\cos\theta_0}$$

où $\alpha_k$ et $\gamma_k$ représentent respectivement les coeffi cients d'absorption et de recouplage du mode de propagation d'ordre k.

Le coefficient de recouplage est proportionnel à la quantité d'énergie diffractée hors de la couche guidante 21. Ce coefficient dépend de la profondeur de modulation du réseau 23.

Ainsi, pour une couche guidante en silicium de 0,58 µm d'épaisseur, le premier mode TE est excité au maximum par un faisceau lumineux 13 dirigé sur le réseau 23 avec un angle d'incidence $\Theta_0$ de l'ordre de 30°, le pas p du réseau étant de 0,35 µm.

Pour un bon fonctionnement du commutateur de l'invention, la divergence du faisceau lumineux 13 envoyé sur le réseau de diffraction 23, doit être inférieure à la largeur angulaire de couplage $\Delta \Theta$.

Un faisceau lumineux 13, envoyé sur le réseau 23 entre l'espace inter-électrodes 11, avec un angle d'incidence $\Theta_i$, différent de $\Theta_0$ et compris entre $\Theta_0$ et $\Theta_0 \mp \Delta \Theta$ est couplé à la couche guidante 21. La fraction du faisceau absorbé dans cette couche crée des porteurs de charges sous le réseau et notamment dans l'espace inter-électrodes 11. Ces porteurs de charges vont diminuer la résistance de l'espace inter-électrodes 11.

Lorsque ce faisceau lumineux d'angle d'incidence $\Theta_i$ est envoyé sur le réseau 23 avec une puissance lumineuse inférieure à la puissance minimale nécessaire pour induire une variation de l'indice de réfraction de la couche guidante 21, les réflexions successives du faisceau lumineux couplé à la couche guidante 21 sont déphasées. Le faisceau perd de ce fait de l'énergie, qui est diffractée hors de la couche guidante 21. Aussi, les porteurs de charges créées dans la couche guidante 21 entre les deux électrodes 5, 7 ne sont pas suffisants pour établir un court-circuit entre les deux électrodes 5, 7.

Par contre, lorsque l'intensité lumineuse du faisceau d'angle d'incidence $\Theta_i$ différent de $\Theta_0$ et compris entre $\Theta_0$ et $\Theta_0 \mp \Delta \Theta$ est supérieure ou égale à l'intensité lumineuse minimale nécessaire pour induire une variation de l'indice de réfraction de là couche guidante, la création de porteurs et/ou l'échauffement résultant de la couche guidante 21 provoquent une variation de l'indice de réfraction du matériau constituant la couche 21. Le signe de $\Theta_i - \Theta_0$ dépend du signe de la variation de l'indice de réfraction. Le signe de $\Theta_i - \Theta_0$ est donc choisi de façon à ce que la variation de l'indice de réfraction de la couche guidante 21 entraîne une amélioration du couplage de ce faisceau lumineux dans la couche guidante 21, autrement dit tende vers un couplage résonnant. La variation de l'indice de réfraction du matériau constituant la couche guidante, par création de porteurs et/ou par échauffement thermique est non linéaire.

L'amélioration du couplage se traduit par une perte moins importante de l'énergie lumineuse. Les porteurs de charges créées dans la couche 21 vont être plus nombreux et vont donc diminuer la résistance de l'espace inter-électrodes jusqu'à l'obtention d'un court-circuit entre les deux électrodes. Le seuil de puissance correspond à l'intensité lumineuse minimale nécessaire pour obtenir brutalement un court-circuit entre les deux électrodes 5,7 pour un faisceau d'angle d'incidence $\Theta_i$, autrement dit pour obtenir un couplage résonnant avec cet angle $\Theta_i$. Plus l'angle $\Theta_i$ est décalé par rapport à l'angle $\Theta_0$, plus le seuil de puissance $P_{si}$

est important.

Un simple réglage de l'angle d'incidence $\Theta_i$ du faisceau lumineux 13 permet de faire fonctionner le commutateur opto-électronique à partir d'un seuil de puissance Psi déterminé.

Par ailleurs, des rayons lumineux absorbés dans la couche guidante 21 mais non couplés à un mode de propagation de ladite couche 21 contribue également mais très faiblement à la création de porteurs de charges.

Le réseau 23 est gravé de préférence sur une longueur supérieure l'espace inter-électrodes 11. Cet espace 11 peut par exemple avoir la forme d'un triangle tronqué au sommet, le sens de propagation du mode étant dirigé vers le sommet du triangle afin que des porteurs de charges soient également créés sous les électrodes pour améliorer les contacts ohmiques entre les électrodes 5, 7 et la couche guidante 21. D'autre part, la largeur du réseau 23 est au moins égale à la largeur des électrodes.

Cependant, pour éviter d'avoir une discontinuité de l'épaisseur de la couche guidante, le réseau peut être gravé sur toute la surface de la couche guidante 21.

Les figures 3a et 3b représentent l'évolution en fonction du temps d'un faisceau lumineux incident impulsionnel de longueur d'onde $\lambda = 1,06$ µm (courbes 31a, 31b), de la tension recueillie en sortie d'un commutateur du type de celui représenté figure 1 (courbes 33a et 33b), et de la tension recueillie en sortie d'un commutateur conforme à l'invention (courbes 35a, 35b).

En abscisses, l'échelle des temps est exprimée en nanosecondes et en ordonnées les courbes 31a et 31b sont exprimées en densité de puissance réduite, autrement dit en puissance par unité de surface normalisée à la densité de puissance maximum de l'impulsion lumineuse, c'est-à-dire environ 750 kW/cm² et les courbes 33a, 33b et 35a, 35b sont exprimées en tension normalisée à la tension maximum de sortie du commutateur, cette dernière correspondant à peu près à la moitié de la tension d'alimentation du commutateur.

Les courbes 33a et 33b ont été obtenues pour un commutateur comprenant une couche 3 en silicium de 50 µm, la durée de vie dês porteurs de charge dans cette lame étant de l'ordre de 500 ns ; les courbes 35a et 35b ont été obtenues pour une couche guidante en silicium de 0,7 µm d'épaisseur, la durée de vie des porteurs de charge dans cette couche étant de l'ordre de 1 ns, pour un réseau de couplage ayant un pas de 0,33 µm, et pour un faisceau lumineux impulsionnel ayant un écart angulaire par rapport à l'angle $\Theta_0$ de -0,26°.

Les courbes 33a, 33b, 35a et 35b résultent d'un commutateur alimenté par une tension de l'ordre de 900 volts et comprenant des électrodes 5, 7 d'impédance adaptée sur 50 $\Omega$ et comportant un espace inter-électrodes 11 de 1 mm.

La courbe 31a représente une impulsion de type gaussien (sans défaut). Le front de montée de la tension de sortie d'un commutateur classique (courbe 33a) est progressif et suit la montée en puissance de l'impulsion lumineuse jusqu'à ce que celle-ci atteigne sa tension maximum. En revanche, le front de montée de la tension de sortie d'un commutateur conforme à l'invention (courbe 35a) est très rapide, il a lieu lorsque l'impulsion lumineuse atteint une certaine densité de puissance qui correspond au seuil de puissance du commutateur dans les conditions décrites précédemment. Comme représenté sur cette courbe, le seuil de puissance est inférieur à la puissance maximum de l'impulsion lumineuse.

La forme de l'impulsion lumineuse représentée sur la courbe 31b, présente un défaut 30 dans son front de montée. Le front de montée de la courbe 33b du commutateur classique est de ce fait plus décalé par rapport au maximum de l'impulsion lumineuse, que celui de la courbe 33a. L'instant de déclenchement d'un commutateur classique est donc lié à la forme de l'impulsion lumineuse ; aussi, l'instant de déclenchement d'un commutateur classique sous l'effet successif de deux impulsions lumineuses de forme différente sera différent.

En revanche, le front de montée de la courbe 35b et donc l'instant de déclenchement d'un commutateur à seuil conforme à l'invention, est identique à celui représenté sur la courbe 35a, cet instant de déclenchement étant déterminé par le passage de la densité de puissance du faisceau lumineux à une densité de puissance déterminée correspondant au seuil de puissance du commutateur.

Les figures 3a et 3b montrent donc que le déclenchement d'un commutateur conforme à l'invention est indépendant de la forme de l'impulsion lumineuse à des puissances inférieures au seuil de puissance.

La description donnée précédemment n'a été donnée bien entendu qu'à titre explicatif et non limitatif, toutes modifications concernant la réalisation et les dimensions de la couche guidante et du réseau de diffraction ou des électrodes peuvent être envisagées sans sortir du cadre de l'invention. En particulier, la largeur de la couche guidante 21 peut par exemple être limitée à la largeur des électrodes pour augmenter la résistance de la couche guidante.

Le commutateur opto-électronique conforme à l'invention permet, par l'utilisation d'une couche guidante mince, d'augmenter la résistance électrique de ladite couche par rapport celle des commutateurs opto-électroniques de l'art antérieur. De ce fait, on peut soit réduire la longueur de l'espace inter-électrodes, soit appliquer de plus fortes tensions. De plus, la faible durée de vie des porteurs de charge permet d'établir sous l'effet d'un faisceau lumineux impulsionnel une continuité électrique brève. D'autre part, la faible épaisseur de la couche guidante permet d'assurer et de conserver l'adaptation de la ligne de propagation sur toute sa longueur.

Le commutateur conforme à l'invention permet en outre par l'utilisation d'un organe de couplage, d'augmenter l'absorption lumineuse dans la couche guidante et de faire fonctionner le commutateur de l'invention à partir d'un seuil de puissance. Ce type de fonctionnement permet notamment de fournir un signal électrique à temps de montée très court par rapport à la durée de la montée en puissance de l'impulsion lumineuse permettant ainsi de s'affranchir des problèmes de reproductibilité des impulsions lumineuses à des puissances inférieures au seuil de puissance.

Par ailleurs, le commutateur de l'invention est réalisable par des techniques connues de la microélectronique.

## Revendications

1. Commutateur opto-électronique à seuil de puissance, permettant d'établir sous l'effet d'un faisceau de lumière incidente impulsionnelle monochromatique et parallèle une conduction électrique momentanée entre une première et une deuxième électrodes normalement isolées, alignées et espacées de façon à former un espace inter-électrodes (11), comprenant des moyens (10) pour appliquer une tension d'alimentation à la première électrode (5), caractérisé en ce qu'il comprend une couche guidante semi-conductrice (21), disposée sur un substrat isolant (19) et servant au transport des ondes lumineuses incidentes, la première et la deuxième électrodes (5, 7) étant déposées sur la surface supérieure de cette couche guidante (21), un réseau optique de diffraction (23) étant gravé dans la couche guidante (21) dans l'espace inter-électrodes (11), la nature et l'épaisseur de la couche guidante (21) ainsi que le pas du réseau et l'angle d'incidence du faisceau étant choisis pour obtenir lors du passage de la puissance du faisceau de lumière par un seuil de puissance déterminé, le passage rapide d'un état de couplage très faible de la lumière incidente dans la couche guidante à un couplage résonnant.

2. Commutateur opto-électronique selon la revendication 1, caractérisé en ce que l'épaisseur de la couche guidante étant de l'ordre de grandeur de la longueur d'onde de la lumière incidente, l'angle d'incidence de cette dernière sur le réseau est choisi pour que le couplage ait lieu selon un mode fondamental de propagation de la lumière dans la couche guidante.

3. Commutateur opto-électronique selon l'une quelconque des revendications 1 et 2, caractérisé en ce que la longueur du réseau optique de diffraction est supérieure à celle de l'espace inter-électrodes, ledit réseau étant situé en partie sous les première et deuxième électrodes.

4. Commutateur opto-électronique selon l'une quelconque des revendications 1 à 3, caractérisé en ce que la largeur du réseau optique de diffraction est au moins égale à celle de l'espace inter-électrodes.

5. Commutateur opto-électronique selon l'une quelconque des revendications 1 à 4, caractérisé en ce que l'espace inter-électrodes a la forme d'un triangle tronqué au sommet.

6. Commutateur opto-électronique selon l'une quelconque des revendications 1 à 5, caractérisé en ce qu'il comprend en outre une électrode de référence (9), isolée des première et deuxième électrodes (5, 7), sur la surface supérieure de la couche guidante (21) ou sur la surface inférieure du substrat (19), formant avec elles une ligne de propagation et portée à un potentiel de référence.

7. Commutateur opto-électronique selon l'une quelconque des revendications 1 à 6, caractérisé en ce que le substrat (19) est du saphir.

8. Commutateur opto-électronique selon l'une quelconque des revendications 1 à 7, caractérisé en ce que la couche guidante (21) est du silicium.

9. Procédé de commande d'un commutateur optoélectronique selon l'une quelconque des revendications 1 à 8, caractérisé en ce qu'un court-circuit est obtenu sous l'effet d'un faisceau (13) de lumière incidente impulsionnelle monochromatique et parallèle, envoyé sur le réseau optique de diffraction (23) avec un angle d'incidence $\Theta_i$ et une puissance supérieure ou égale à un seuil de puissance $P_{si}$, le seuil de puissance $P_{si}$ correspondant la puissance minimale nécessaire à l'obtention rapide d'un couplage résonnant dans la couche guidante du faisceau de lumière d'angle d'incidence $\Theta_i$, différent de $\Theta_0$ et compris entre $\Theta_0$ et $\Theta_0 \mp \Delta\Theta$, l'angle d'incidence $\Theta_0$ correspondant à un couplage résonnant dans la couche guidante d'un faisceau de lumière de puissance inférieure à la puissance minimale nécessaire pour induire une variation de l'indice de réfraction de la couche guidante, et $\Delta\Theta$ correspondant à la largeur angulaire de couplage.

0228312

FIG. 1

FIG. 2a

FIG. 2b

FIG. 3a

FIG. 3b

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | IEEE TRANSACTIONS ON ELECTRON DEVICES, vol. ED-27, no. 1, janvier 1980, pages 62-65, IEEE, New York, US; SHANG-BIN KO et al.: "The use of multiple internal reflection on extrinsic silicon infrared detection" * Figures 1a,1b; page 62, colonne de droite, ligne 11 - page 63, colonne de gauche, ligne 33 * | 1,4,8 | H 03 K   17/78 H 01 L   31/08 |
| A | ELECTRONICS LETTERS, vol. 18, no. 20, septembre 1982, pages 885-887, Londres, GB; V. BRÜCKNER et al.: "Ultrafast optoelectronic switching in CdS" * Figure 1; page 885, colonne de droite, ligne 1 - page 886, colonne de gauche, ligne 8 * | 1 | |
| A | APPLIED PHYSICS LETTERS, vol. 39, no. 6, 15 septembre 1981, pages 480-482, American Institute of Physics, New York, US; A.P. DeFONZO: "Picosecond photoconductivity in germanium films" * Figure 1; page 480, colonne de gauche, ligne 1 - colonne de droite, ligne 17 * | 1,7 | **DOMAINES TECHNIQUES RECHERCHES (Int. Cl.4)** H 03 K H 01 L |
| A | US-A-3 917 943  (D.H. AUSTON) | | |

-/-

Le présent rapport de recherche a été établi pour toutes les revendications

| Lieu de la recherche LA HAYE | Date d'achèvement de la recherche 10-02-1987 | Examinateur CONRAD V.HEYDENDORFF |
|---|---|---|

## DOCUMENTS CONSIDERES COMME PERTINENTS

Page   2

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-4 490 709  (R.B. HAMMOND et al.) <br><br> ----- | | |
| | | | **DOMAINES TECHNIQUES RECHERCHES (Int. Cl.4)** |

Le présent rapport de recherche a été établi pour toutes les revendications

| Lieu de la recherche | Date d'achèvement de la recherche | Examinateur |
|---|---|---|
| LA HAYE | 10-02-1987 | CONRAD V.HEYDENDORFF |